# EUROPEAN PATENT APPLICATION

(11) **EP 4 693 896 A1**
(43) Date of publication of application: **11.02.2026**
(21) Application number: 25192775.2
(22) Date of filing: 30.07.2025
(51) Int. Cl.: H03F 1/32, H03F 3/189, H03F 3/24

(54) **DIGITAL PRE-DISTORTION COEFFICIENT ESTIMATING DEVICE AND OPERATING METHOD THEREOF**

(30) Priority: 07.08.2024 KR 20240105745
(71) Applicant: Samsung Electronics Co., Ltd., Suwon-si, Gyeonggi-do 16677 (KR)
(72) Inventor: KIM, Joontae, 16677 Suwon-si (KR); PARK, Minjae, 16677 Suwon-si (KR); YU, Hyunseok, 16677 Suwon-si (KR); YOON, Youngjun, 16677 Suwon-si (KR)
(74) Representative: Marks & Clerk LLP

(57) **Abstract**

An adaptive digital pre-distortion device includes a legacy digital pre-distortion (DPD) device, one or more processors including processing circuitry, and a memory storing instructions. The instructions, when executed by the one or more processors individually or collectively, cause the adaptive DPD device to receive a plurality of system parameters, estimate, using a neural network, one or more coefficients of the legacy DPD device, and apply the one or more coefficients to the legacy DPD device. The neural network is configured to generate, as outputs, the one or more coefficients based on the plurality of system parameters.

## Description

### BACKGROUND

### 1. Field

The present disclosure relates generally to power amplifiers, and more particularly, to a digital pre-distortion coefficient estimating device and an operating method of the device.

### 2. Description of Related Art

Digital pre-distortion (DPD) may refer to a technology that may potentially save power by lowering and/or minimizing a bias voltage of a power amplifier (PA), and/or may utilize, for transmission, a nonlinearity that may increase. That is, a response of the PA may be reverse-compensated in advance to adjust the response to be substantially linear and/or nearly linear. The adjustment may be performed through pre-distortion in the digital domain.

The DPD may be applied to various power amplification scenarios. For example, DPD coefficients and/or DPD responses may be generated according to several representative scenarios in advance, and for similar power amplification scenarios such as, but not limited to, adjacent frequencies and/or adjacent transmission powers, the DPD coefficients and/or DPD responses may be used as is without modification. Alternatively or additionally, only the bias voltage of the PA may adjusted based on an indicator such as, but not limited to, an adjacent channel leakage ratio (ACLR) at a fixed DPD coefficient. That is, in a situation where the linearity of the PA may not be guaranteed due to, for example, an inability to respond to all possible power amplification scenarios based only on a fixed DPD coefficient or by partially modifying the bias voltage of the PA, or the like, a transmission capability and/or performance of the PA may deteriorate. Accordingly, there exists a need for further improvements in power amplifier technology, as the need for transmission performance may be constrained by an inability to respond to possible power amplification scenarios. Improvements are presented herein. These improvements may also be applicable to other technologies.

### SUMMARY

One or more example embodiments of the present disclosure provide a digital pre-distortion coefficient estimating device and an operating method of the device, wherein the device learns and infers a coefficient of a digital pre-distortion, based on a neural network that takes system parameters as inputs.

According to an aspect of the present disclosure, an adaptive digital pre-distortion device includes a legacy digital pre-distortion (DPD) device, one or more processors including processing circuitry, and a memory storing instructions. The instructions, when executed by the one or more processors individually or collectively, cause the adaptive DPD device to receive a plurality of system parameters, estimate, using a neural network, one or more coefficients of the legacy DPD device, and apply the one or more coefficients to the legacy DPD device. The neural network is configured to generate, as outputs, the one or more coefficients based on the plurality of system parameters.

According to an aspect of the present disclosure, an electronic device includes a communication circuit including an adaptive DPD device including a legacy DPD device and a neural network device, and a power amplifier configured to amplify an output of the adaptive DPD device, a processor configured to determine an operation mode of the neural network device, and provide the plurality of system parameters to the neural network device, and a memory storing weights of the neural network device. The neural network device is configured to receive a plurality of system parameters as inputs, and generate coefficients of the legacy DPD device as outputs.

According to an aspect of the present disclosure, an operating method of an electronic device includes receiving a plurality of system parameters, generating, using a neural network, coefficients of a legacy DPD device of the electronic device, based on the plurality of system parameters, applying the coefficients to the legacy DPD device, receiving, using the legacy DPD device, modulated transmission data, performing, using the legacy DPD device, pre-distortion on the modulated transmission data, and amplifying a signal on which the pre-distortion is performed.

Additional aspects may be set forth in part in the description which follows and, in part, may be apparent from the description, and/or may be learned by practice of the presented embodiments.

At least some of the above and other features of the invention are set out in the claims.

### BRIEF DESCRIPTION OF THE DRAWINGS

The above and other aspects, features, and advantages of certain embodiments of the present disclosure may be more apparent from the following description taken in conjunction with the accompanying drawings, in which:
FIG. 1 is a block diagram illustrating an electronic device, according to an embodiment;
FIG. 2 is a block diagram of a communication circuit, according to an embodiment;
FIG. 3 illustrates an example of a transmission path, according to a comparative example;
FIG. 4 illustrates an example of a transmission path, according to an embodiment;
FIG. 5 is an example of a neural network, according to an embodiment;
FIG. 6 illustrates an example of an adaptive digital pre-distortion block, according to an embodiment;
FIG. 7 illustrates a transmission path corresponding to an online structure, according to an embodiment.
FIG. 8A illustrates an example of a neural network corresponding to an offline structure, according to an embodiment;
FIG. 8B illustrates another example of a neural network corresponding to an offline structure, according to an embodiment; and
FIG. 9 is a block diagram of a wireless communication device, according to an embodiment.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be examples only. Therefore, those of ordinary skill in the art may recognize that various changes and modifications of the embodiments described herein may be made without departing from the scope of the disclosure. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

It is to be understood that the specific order or hierarchy of blocks in the processes/flowcharts disclosed are an illustration of example approaches. Based upon design preferences, it is understood that the specific order or hierarchy of blocks in the processes/flowcharts may be rearranged. Further, some blocks may be combined or omitted. The accompanying claims present elements of the various blocks in a sample order, and are not meant to be limited to the specific order or hierarchy presented.

The embodiments herein may be described and illustrated in terms of blocks, as shown in the drawings, which carry out a described function or functions. These blocks, which may be referred to herein as blocks, units, modules, or the like, or by names such as device, logic, circuit, controller, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

Hereinafter, various embodiments of the present disclosure are described with reference to the accompanying drawings.

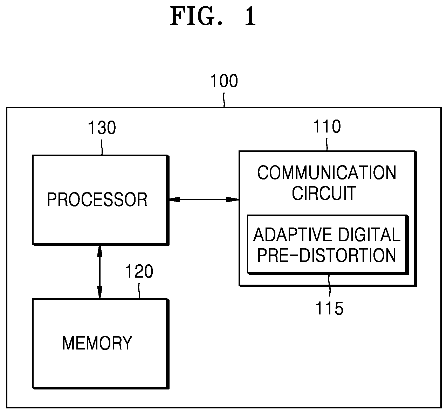

FIG. 1 is a block diagram illustrating an electronic device 100, according to an embodiment.

Referring to FIG. 1, the electronic device 100 may include a communication circuit 110, a memory 120, and a processor 130.

According to an embodiment, the communication circuit 110 may perform functions for transmitting and/or receiving signals to and/or from an external device over a wireless and/or a wired channel. The external device may be and/or may include, but not be limited to, a base station and/or other electronic device. For example, the communication circuit 110 may perform a conversion function between a baseband signal and a bit stream according to the physical layer specifications of a system. For example, when transmitting data to the external device, the communication circuit 110 may generate complex symbols by encoding and/or modulating a transmission bit stream, and when receiving data from the external device, the communication circuit 110 may restore a reception bit stream by demodulating and/or decoding a baseband signal.

Additionally, the communication circuit 110 may up-convert a baseband signal into a radio frequency (RF) band signal and transmit the converted signal through an antenna and/or may down-convert an RF band signal received, through an antenna, into a baseband signal. For example, the communication circuit 110 may include a transmitting filter, a receiving filter, a power amplifier, a mixer, an oscillator, a digital-to-analog converter (DAC), an analog-to-digital converter (ADC), or the like. The communication circuit 110 may perform beamforming. To impart directionality to signals to be transmitted and/or received, the communication circuit 110 may apply a beamforming weight to the signals.

The communication circuit 110 may transmit and receive signals to and from the external device. For example, the communication circuit 110 may receive a downlink signal from the base station. The downlink signal may include a synchronization signal (SS), a reference signal (RS), system information, a configuration message, control information, downlink data, or the like.

According to an embodiment, the communication circuit 110 may include an adaptive digital pre-distortion block 115. The adaptive digital pre-distortion block 115 may adaptively change a coefficient of a digital pre-distortion according to a power amplification scenario. The power amplification scenario may refer to a combination of factors that may determine the characteristics of a power amplifier. For example, the power amplification scenario may refer to a combination of at least one system parameter that may affect the linearity of a power amplifier. The system parameters may include at least one of a type of power amplifier, a system bandwidth, a modulation order, a bias voltage of the power amplifier, an output voltage of the power amplifier, a target voltage of the power amplifier, a gain of the power amplifier, an operation frequency of the power amplifier, a center frequency of the power amplifier, or the like. That is, if at least one of the system parameters of the power amplification scenario is changed, the power amplification scenario may be understood as a different power amplification scenario from the previous power amplification scenario.

The adaptive digital pre-distortion block 115 may be based on a neural network that may receive, as inputs, the system parameters and outputs coefficients to be used in a legacy digital pre-distortion. For example, the neural network may receive, as an input, a bias voltage, gain, operation frequency, or the like of the power amplifier, and may output a coefficient that may maximize the linearity of an output of the power amplifier.

The memory 120 may store data such as, but not limited to, basic programs, application programs, setting information, or the like that may be used in the operation of the electronic device 100. The memory 120 may be and/or may include volatile memory, non-volatile memory, and/or a combination of volatile memory and non-volatile memory. the memory 120 may provide stored data upon request of the processor 130. According to an embodiment, the memory 120 may store data for learning and/or inferring coefficients of the adaptive digital pre-distortion block 115. For example, the memory 120 may store weights of a neural network included in the adaptive digital pre-distortion block 115. As another example, the memory 120 may further include a buffer memory. The buffer memory may be and/or may include a memory for temporarily storing output data of the power amplifier for a certain period of time. The adaptive digital pre-distortion block 115 may update the weights of the neural network stored in the buffer memory by performing training based on the output data of the power amplifier.

The processor 130 may control the overall operations of the electronic device 100. For example, the processor 130 may transmit and/or receive signals to and/or from the external device through the communication circuit 110. Additionally, the processor 130 may write and/or read data to and/or from the memory 120. To this end, the processor 130 may be and/or may include at least one processor or microprocessor, or may be a portion of a processor (e.g., a core). For example, the processor 130 may be implemented using one or more general-purpose or special purpose computers, such as, for example, a processor, a controller, an arithmetic logic unit (ALU), a digital signal processor, a microcomputer, a field programmable gate array (FPGA), a programmable logic unit (PLU), a microprocessor, or any other device capable of responding to and executing instructions in a defined manner. When the processor 130 is a portion of a processor, a portion of the communication circuit 110 and the processor 130 may be referred to as a communication processor (CP). The adaptive digital pre-distortion block 115 may be implemented as a digital circuit, and/or may be incorporated into the processor 130. For purpose of simplicity, the description the processor 130 is used as singular; however, one skilled in the art may appreciate that the processor 130 may include multiple processing elements and/or multiple types of processing elements. For example, the processor 130 may include multiple processors or a processor and a controller. In addition, different processing configurations may be possible, such as, parallel processors.

According to an embodiment, the processor 130 may determine an operation mode of the adaptive digital pre-distortion block 115. For example, the processor 130 may determine one of the following operation modes: a first operation mode in which the adaptive digital pre-distortion block 115 performs training of a neural network for each sample; a second operation mode in which the adaptive digital pre-distortion block 115 stores output data of the power amplifier in the buffer memory and performs training of the neural network for each output data of a predetermined size, based on the output data stored in the buffer memory; and a third operation mode in which the performance indicators of the power amplifier are monitored and training of the neural network is performed in response to the performance indicators falling below a certain level.

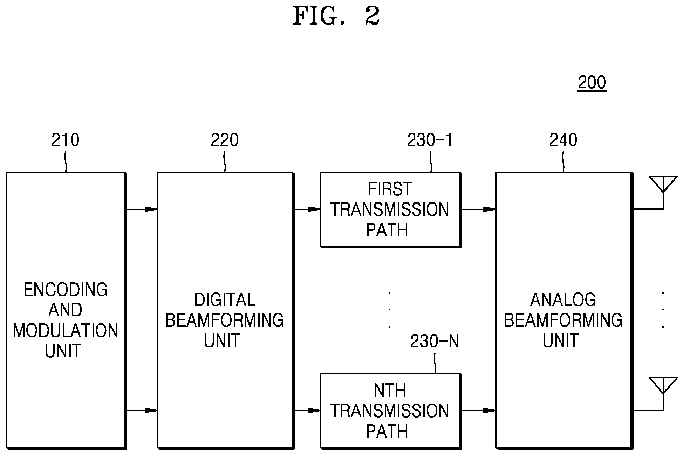

FIG. 2 is a block diagram of a communication circuit, according to an embodiment.

Referring to FIG. 2, the communication circuit 200 may include an encoding and modulation unit 210, a digital beamforming unit 220, a plurality of transmission paths 230 (e.g., a first transmission path 230-1 to an N-th transmission path 230-N, where N is a positive integer greater than one (1)), and an analog beamforming unit 240. The communication circuit 200 of FIG. 2 may include and/or may be similar in many respects to the communication circuit 110 described above with reference to FIG. 1, and may include additional features not mentioned above. Consequently, repeated descriptions of the communication circuit 110 described above with reference to FIG. 1 may be omitted for the sake of brevity.

The encoding and modulation unit 210 may perform channel encoding. For example, the encoding and modulation unit 210 may perform channel encoding based on at least one of a low-density parity check (LDPC) code, a convolution code, a polar code, or the like. The encoding and modulation unit 210 may generate modulation symbols by performing constellation mapping.

The digital beamforming unit 220 may perform beamforming on digital signals (e.g., modulation symbols). For example, the digital beamforming unit 220 may multiply beamforming weights by modulation symbols. That is, the beamforming weights may be used to change the magnitude and/or phase of a signal, and/or may be referred to as a precoding matrix, a precoder, or the like. The digital beamforming unit 220 may output digital-beamformed modulation symbols to the plurality of first to N-th transmission paths 230-1 to 230-N. In an embodiment, according to a multiple input multiple output (MIMO) transmission scheme, modulation symbols may be multiplexed, and/or the same modulation symbols may be provided to the plurality of first to N-th transmission paths 230-1 to 230-N.

The plurality of first to N-th transmission paths 230-1 to 230-N may convert digital-beamformed digital signals into analog signals. That is, each of the plurality of first to N-th transmission paths 230-1 to 230-N may include an inverse fast Fourier transform (IFFT) operation unit, a cyclic prefix (CP) insertion unit, a DAC, an up-conversion unit, or the like. The CP insertion unit may be used to perform orthogonal frequency division multiplexing (OFDM) and, as such, may be omitted when another physical layer method (e.g., filter bank multi-carrier (FBMC)) is applied. In an embodiment, the plurality of first to N-th transmission paths 230-1 to 230-N may provide independent signal processing processes for multiple streams generated through digital beamforming. However, depending on the implementation method, some of the components of the plurality of first to N-th transmission paths 230-1 to 230-N may be used in common.

The analog beamforming unit 240 may perform beamforming on an analog signal. For example, the analog beamforming unit 240 may multiply beamforming weights by analog signals. That is, the beamforming weights may be used to change the magnitude and/or phase of the signal.

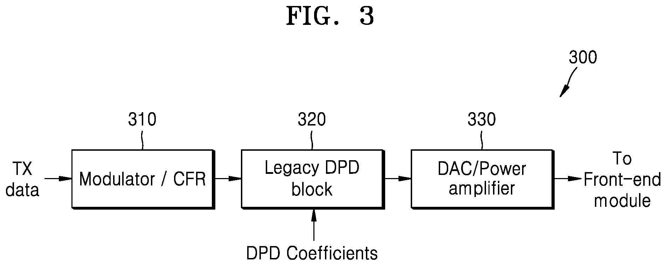

FIG. 3 illustrates an example of a transmission path, according to a comparative example.

Referring to FIG. 3, a transmission path 300 may include a modulator/crest factor reduction (CFR) block 310, a legacy digital pre-distortion (DPD) block 320, and a DAC/PA block 330. The transmission path 300 of FIG. 3 may include and/or may be similar in many respects to at least one of the plurality of first to N-th transmission paths 230-1 to 230-N described above with reference to FIG. 2, and may include additional features not mentioned above. Consequently, repeated descriptions of the transmission path 300 described above with reference to FIG. 2 may be omitted for the sake of brevity

The modulator/CFR block 310 may receive transmission data TX data from a digital baseband and modulate the received transmission data TX data. For example, the modulator/CFR block 310 may modulate the transmission data TX data based on various modulation techniques such as, but not limited to, binary phase shift keying (BPSK), quadrature phase shift keying (QPSK), quadrature amplitude modulation (16-QAM), and 64-QAM. However, the modulation performed in the modulator/CFR block 310 is not limited to the above-described techniques and may include other modulation techniques.

The modulator/CFR block 310 may perform crest factor reduction on the modulated transmission data TX data. The CFR may refer to performing clipping on the modulated transmission data TX data. That is, after passing through a power amplifier, a peak component may be removed in order to reduce and/or prevent a high peak to average power ratio (PAPR). The transmission data TX data modulated and clipped by the modulator/CFR block 310 may be input to the legacy DPD block 320.

The legacy DPD block 320 may receive the modulated transmission data TX data and perform pre-distortion on the modulated transmission data TX data. The pre-distortion may refer to adjusting data such that, considering the non-linear output of the DAC/PA block 330 of a next stage, a signal input to the DAC/PA block 330 may be provided after pre-distorting the signal in advance so that a linear output of the DAC/PA block 330 may be generated. The legacy DPD block 320 may correspond to any circuit and/or functional block that may perform a related DPD function.

The DAC/PA block 330 may generate an input for a front-end module. For example, the DAC/PA block 330 may perform a digital-to-analog conversion of pre-distorted transmission data TX data from the legacy DPD block 320. Alternatively or additionally, the DAC/PA block 330 may amplify the signal strength of the analog converted signal through a power amplifier and output the same to the front-end module.

As a comparative example, the legacy DPD block 320 may perform pre-distortion on the modulated transmission data TX data based on at least one fixed coefficient (e.g., DPD coefficients). For example, an electronic device, according to the comparative example, may store, as a look-up table (LUT), DPD coefficients for respective power amplification scenarios. For example, the LUT may pre-store, for example, a first DPD coefficient for making an output of a power amplifier linear in a first power amplification scenario (e.g., the center frequency may be a first frequency, and the bias voltage may be a first voltage value), a second DPD coefficient for making an output of a power amplifier linear in a second power amplification scenario (e.g., the center frequency may be a second frequency, and the bias voltage may be a second voltage value). The legacy DPD block 320 may perform pre-distortion by loading DPD coefficients that may match a power amplification scenario. For new power amplification scenarios that may not be stored in the LUT, there may be no DPD coefficients matching the new power amplification scenarios. Accordingly, the legacy DPD block 320 may perform pre-distortion by using DPD coefficients corresponding to the power amplification scenario that may be most similar to the new power amplification scenario, or by changing some of the settings of the power amplifier (e.g., bias voltage, or the like). However, in such a case, the linearity of the power amplifier may decrease.

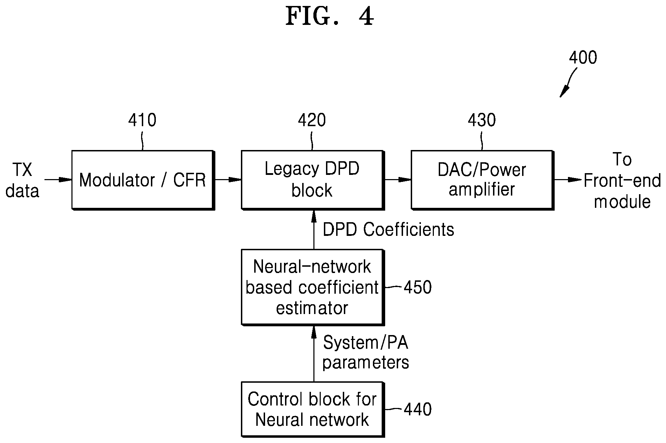

FIG. 4 illustrates an example of a transmission path, according to an embodiment.

Referring to FIG. 4, a transmission path 400 may include a modulator/CFR block 410, a legacy DPD block 420, a DAC/PA block 430, a neural network (NN) control block 440, and a coefficient estimator 450. The transmission path 400 of FIG. 4 may include and/or may be similar in many respects to at least one of the plurality of first to N-th transmission paths 230-1 to 230-N described above with reference to FIG. 2, and may include additional features not mentioned above. Furthermore, the modulator/CFR block 410, the legacy DPD block 420, and the DAC/PA block 430 of FIG. 4 may include and/or may be similar in many respects, respectively, to the modulator/CFR block 310, the legacy DPD block 320, and the DAC/PA block 330 described above with reference to FIG. 3, and may include additional features not mentioned above. Consequently, repeated descriptions of the transmission path 400 described above with reference to FIGS. 2 and 3 may be omitted for the sake of brevity.

According to an embodiment, the NN control block 440 may control the overall operation of a neural network of the coefficient estimator 450. The NN control block 440 may determine an operation mode of the neural network and may provide inputs for training of the neural network. In an embodiment, the NN control block 440 may provide system parameters as inputs for training of the neural network. The system parameters may include all factors affecting linearity of an output of a power amplifier. For example, the system parameters may include at least one of the type of power amplifier, system bandwidth, modulation order, bias voltage of the power amplifier, output voltage, target voltage, gain, operation frequency, center frequency, or the like of the power amplifier.

In an embodiment, the NN control block 440 may determine the operation mode of the neural network. When the electronic device 100 is operating in a low power mode, the NN control block 440 may deactivate the first operation mode that may perform training for each sample of transmission data to reduce resources and power consumed for learning and inference of the neural network. Alternatively, the NN control block 440 may temporarily store the transmission data in a buffer memory, and when the buffer memory is full, may activate the second operation mode to train the neural network based on the stored transmission data. However, if the electronic device 100 is not operating in a low power mode and/or may have sufficient resources and power for learning and inference of the neural network, the NN control block 440 may set the neural network to the first operation mode.

Alternatively, the NN control block 440 may select the third operation mode that directs training of the neural network, based on monitoring of the performance of the power amplifier, instead of performing learning for every sample and/or a fixed amount of transmission data. The NN control block 440 may monitor indicators representing the performance of the power amplifier. For example, the NN control block 440 may monitor metrics such as adjacent channel leakage ratio (ACLR) to determine if the performance of the power amplifier has degraded. The ACLR is only an example of one of the indicators that may represent the performance of the power amplifier, and the NN control block 440 may monitor all indicators that may represent the performance of the power amplifier. The NN control block 440 may determine that the ACLR falls below a threshold value. Falling of the ACLR below a threshold value may indicate that the performance indicator of the power amplifier has declined because the DPD coefficients inferred through the neural network and provided to the legacy DPD block 420 may not be optimal. Accordingly, the NN control block 440 may perform training of the neural network in response to the performance indicator of the power amplifier, the indicator falling below a threshold value. The training of the neural network may be performed for each sample of transmission data, and/or may be performed based on transmission data temporarily stored in buffer memory.

According to an embodiment, the coefficient estimator 450 may output DPD coefficients based on the neural network. The output DPD coefficients may be optimal coefficients for the output of the power amplifier to exhibit optimal linearity in a given power amplification scenario. The input of the coefficient estimator 450 may be a combination of system parameters. The combination of system parameters may be referred to as a power amplification scenario.

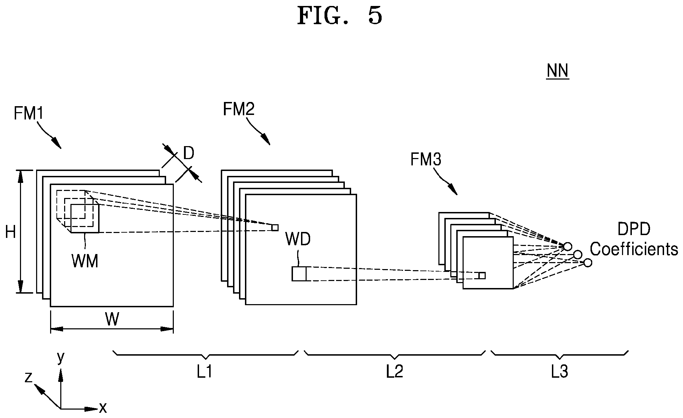

FIG. 5 is an example of a neural network, according to an embodiment.

Referring to FIG. 5, the neural network NN may include a plurality of layers (e.g., a first layer L1, a second layer L2, and a third layer L3). The neural network NN of FIG. 5 may include and/or may be similar in many respects to the coefficient estimator 450 described above with reference to FIG. 4, and may include additional features not mentioned above. Consequently, repeated descriptions of the neural network NN described above with reference to FIG. 4 may be omitted for the sake of brevity.

Each of the plurality of layers L1 to L3 may be and/or may include a linear layer and/or a non-linear layer, and in some embodiments, at least one linear layer and at least one non-linear layer may be combined and referred to as one layer. For example, the linear layer may include convolutional layers and fully connected layers, and the non-linear layer may include sampling layers, pooling layers, and activation layers.

For example, the first layer L1 may be a convolutional layer and the second layer L2 may be a sampling layer. The neural network NN may further include an activation layer and may further include layers that may perform different types of computations.

Each of the plurality of layers L1 to L3 may receive input data and/or a feature map generated from a previous layer as an input feature map, and may generate an output feature map by calculating the input feature map. The feature map may refer to data in which various features of input data are expressed. Feature maps (e.g., a first feature map FM1, a second feature map FM2, and a third feature map FM3) may have the form of, for example, a two-dimensional (2D) matrix or a three-dimensional (3D) matrix. The first to third feature maps FM1 to FM3 have a width W (or called a column), a height H (or called a row), and a depth D, which may correspond to the x-axis, y-axis, and z-axis on the coordinate system, respectively. The depth D may be referred to as the number of channels.

The first layer L1 may generate a second feature map FM2 by convolving the first feature map FM1 with a weight map WM. The weight map WM may filter the first feature map FM1 and may be referred to as a filter or kernel. For example, the depth of the weight map WM (e.g., the number of channels) may be the same as the depth of the first feature map FM1 (e.g., the number of channels) and the same channels of the weight map WM and the first feature map FM1 may be convolved. The weight map WM may be shifted by traversing the first feature map FM1 by using a sliding window. An amount shifted may be referred to as a stride length or stride. During each shift, each of the weights included in the weight map WM may be multiplied by and added with all feature values in areas overlapping the first feature map FM1. As the first feature map FM1 and the weight map WM may be convolved with each other, one channel of the second feature map FM2 may be generated. Although one weight map WM is shown in FIG. 2, in practice, multiple weight maps may be convolved with the first feature map FM1 to generate a plurality of channels of the second feature map FM2. That is, the number of channels of the second feature map FM2 may correspond to the number of weight maps.

The second layer L2 may generate the third feature map FM3 by changing the spatial size of the second feature map FM2. For example, the second layer L2 may be a sampling layer. The second layer L2 may perform upsampling and/or downsampling, and the second layer L2 may select some of data included in the second feature map FM2. For example, a window WD that is two-dimensional (2D) may be shifted on the second feature map FM2 in units of the size of the window WD (e.g., a 4×4 matrix), and a value at a certain location (e.g., 1 row and 1 column) may be selected in an area overlapping with the window WD. The second layer L2 may output the selected data as data of the third feature map FM3. As another example, the second layer L2 may be a pooling layer. In this case, in the second layer L2, the maximum value (or average value of feature values) of the feature values in an area overlapping the window WD in the second feature map FM2 may be selected. The second layer L2 may output the selected data as data of the third feature map FM3. Accordingly, the third feature map FM3 having a changed spatial size may be generated from the second feature map FM2. The number of channels of the third feature map FM3 may be the same as the number of channels of the second feature map FM2.

In some embodiments, the second layer L2 may not be limited to a sampling layer or a pooling layer. That is, the second layer L2 may be a convolutional layer, similar to the first layer L1. In such an embodiment, the second layer L2 may generate the third feature map FM3 by convolving the second feature map FM2 with a weight map. In this case, the weight map on which the convolution operation was performed in the second layer L2 may be different from the weight map WM on which the convolution operation was performed in the first layer L1.

An Nth feature map may be generated from an Nth layer through a plurality of layers including the first layer L1 and the second layer L2. The Nth feature map may be input to a reconstruction layer located at a back end of the neural network from which the output data is output. The reconstruction layer may generate output data based on the Nth feature map. The output data may be DPD coefficients to be provided to a legacy DPD block 420. In addition, the reconstruction layer may receive multiple feature maps, such as the first feature map FM1 and the second feature map FM2, in addition to the Nth feature map, and generate output data based on the multiple feature maps.

The third layer L3 may generate output data for input data by combining features of the third feature map FM3. For example, input data may be a combination of system parameters. In this case, the third layer L3 may generate output data corresponding to the DPD coefficients, based on the third feature map FM3 provided from the second layer L2.

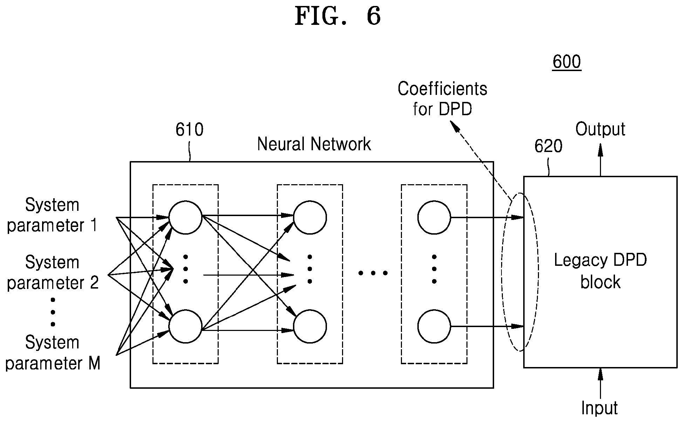

FIG. 6 illustrates an example of an adaptive digital pre-distortion block 600, according to an embodiment.

The adaptive digital pre-distortion block 600 of FIG. 6 may include and/or may be similar in many respects to the adaptive digital pre-distortion block 115 described above with reference to FIG. 1, and may include additional features not mentioned above. Consequently, repeated descriptions of the adaptive digital pre-distortion block 600 described above with reference to FIG. 1 may be omitted for the sake of brevity. Referring to FIG. 6, the adaptive digital pre-distortion block 600 may include a neural network 610 for estimation of DPD coefficients and a legacy DPD block 620. The neural network 610 may be a pre-trained neural network.

According to an embodiment, the neural network 610 may receive M system parameters as inputs, where M is a positive integer greater than zero (0). For example, the M system parameters may include all factors affecting the linearity of an output of a power amplifier. For example, the system parameters may include at least one of the type of power amplifier, a system bandwidth, a modulation order, a bias voltage, an output voltage, a target voltage, a gain, an operation frequency, a center frequency of the power amplifier, or the like. The neural network 610 may generate output data across a plurality of layers, as described above with reference to FIG. 5.

According to an embodiment, the neural network 610 may provide a plurality of DPD coefficients as output data, to the legacy DPD block 620. The plurality of DPD coefficients may be DPD coefficients inferred to ensure that the output of the power amplifier exhibits optimal linearity in the case of a new power amplification scenario (e.g., a combination of system parameters input to the neural network 610).

Accordingly, the electronic device 100, according to the present disclosure, may achieve a relatively high performance of the power amplifier by inferring through the neural network 610 without having to learn new DPD coefficients when experiencing a new power amplification scenario while using the legacy DPD block 620.

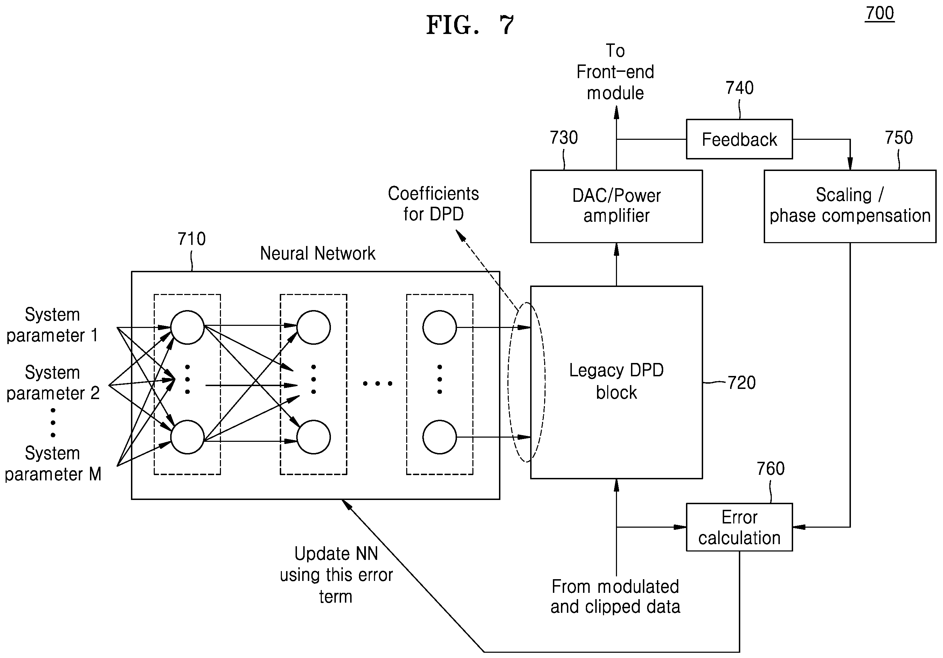

FIG. 7 illustrates a transmission path corresponding to an online structure, according to an embodiment.

Referring to FIG. 7, a transmission path 700 may include a neural network 710, a legacy DPD block 720, a DAC/PA block 730, a feedback block 740, a scaling/phase compensation block 750, and an error calculation block 760. The neural network 710 and the legacy DPD block 720 of FIG. 7 may correspond to the neural network 610 and the legacy DPD block 620 of FIG. 6, respectively, and repeated description descriptions thereof may be omitted for the sake of brevity.

A transmission path corresponding to the online structure may refer to a structure that may perform learning and inference of the neural network 710 in parallel while transmitting transmission data from the electronic device 100.

In some embodiments, the DAC/PA block 730 may analog-convert and power-amplify the output of the legacy DPD block 720. The DAC/PA block 730 may provide the amplified signal to the front-end module.

According to an embodiment, the feedback block 740 may receive a signal output from the DAC/PA block 730 as feedback to the front-end module. Thereafter, the feedback block 740 may provide the fed back signal to the scaling/phase compensation block 750.

According to an embodiment, the scaling/phase compensation block 750 may perform a series of operations to compare an output signal of the power amplifier with an input signal of the legacy DPD block 720. For example, the scaling/phase compensation block 750 may perform scaling to return the size of the output signal amplified by the gain of the power amplifier to the size of the input signal of the legacy DPD block 720. Thereafter, the scaling/phase compensation block 750 may perform phase and delay compensation on the scaled signal. For example, a scaled signal may experience phase change and delay as the signal passes through various signal processing blocks, such as, but not limited to, the legacy DPD block 720, the DAC/PA block 730, a mixer, a down converter, or the like. Thus, the scaling/phase compensation block 750 may perform compensation for phase and delay on the scaled signal.

According to an embodiment, the error calculation block 760 may calculate an error by comparing an input signal of the legacy DPD block 720 with an output signal of the scaling/phase compensation block 750. The error calculation block 760 may calculate an error by subtracting, from the input signal of the legacy DPD block 720, the output signal of the scaling/phase compensation block 750, which may be a signal fed back from the input signal of the legacy DPD block 720. The error calculation block 760 may provide the calculated error to the neural network 710. The neural network 710 may perform learning by updating the weights of the neural network 710 by performing a back propagation operation based on the error received from the error calculation block 760.

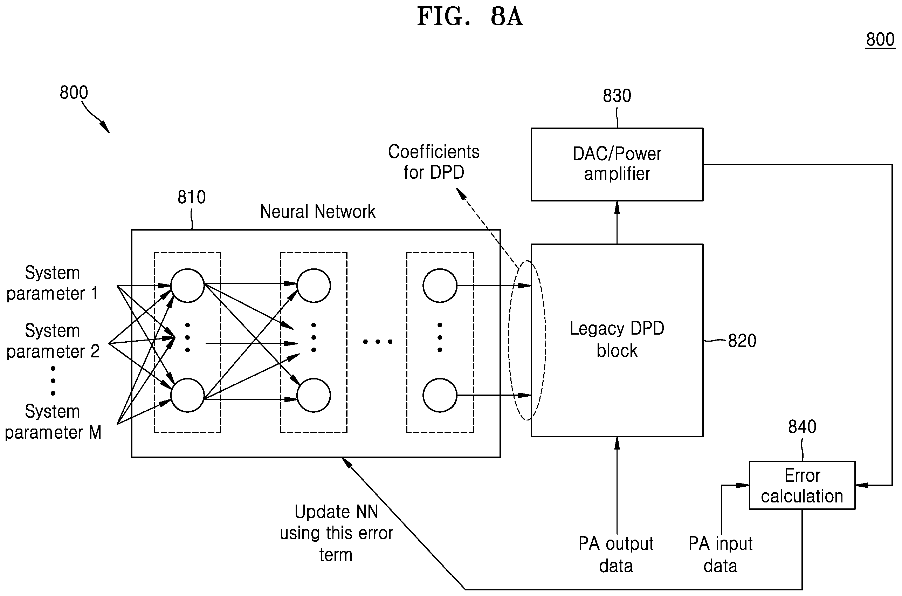

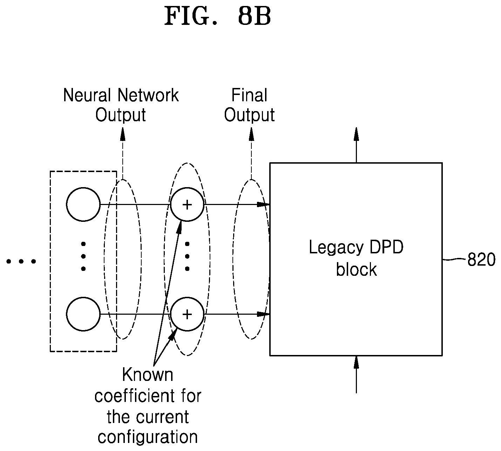

FIG. 8A illustrates an example of a neural network corresponding to an offline structure, according to an embodiment. FIG. 8B illustrates another example of a neural network corresponding to an offline structure, according to an embodiment.

Referring to FIG. 8A, a transmission path 800 may include a neural network 810, a legacy DPD block 820, and an error calculation block 840. The neural network 810 and the legacy DPD block 820 may correspond to the neural network 610 and the legacy DPD block 620 of FIG. 6, respectively, and repeated description descriptions thereof may be omitted for the sake of brevity.

A transmission path corresponding to the offline structure may refer to a structure in which the electronic device 100 may not transmit transmission data to the external device and the legacy DPD block 820 may exist for learning and inference of the neural network 810.

According to an embodiment, the legacy DPD block 820 may receive an output signal of the DAC/PA block 830 as an input signal. The legacy DPD block 820 may perform pre-distortion on the output signal of the DAC/PA block 830 and output the pre-distorted output signal to the DAC/PA block 830. Additionally, the legacy DPD block 820 may provide the pre-distorted output signal to the error calculation block 840.

In some embodiments, the DAC/PA block 830 may receive the pre-distorted output signal via the legacy DPD block 820 and perform analog conversion and power amplification on the received pre-distorted output signal. The DAC/PA block 830 may provide the amplified signal back to the legacy DPD block 820 as an input signal. Additionally, the DAC/PA block 830 may provide the amplified signal to the error calculation block 840.

According to an embodiment, the error calculation block 840 may receive the input signal and the output signal of the DAC/PA block 830, respectively, and calculate a difference between the input signal and the output signal as an error. The error calculation block 840 may provide the calculated error to the neural network 810. The neural network 810 may perform learning by updating weights of the neural network 810 by performing a backpropagation operation based on the error received from the error calculation block 840.

Referring to FIG. 8B, N adders may be arranged between the neural network 810 and the legacy DPD block 820. N may correspond to the number of DPD coefficients, and may be a positive integer greater than zero (0). In some embodiments, the neural network 810 may have already learned DPD coefficients that may match combinations of the system parameters that may be inputs to a neural network. In this case, the NN control block 440 may provide preset DPD coefficients to the N adders. By adding values of the preset DPD coefficients to an output of the neural network 810 and providing a result thereof to the legacy DPD block 820, learning may be performed only on the residual.

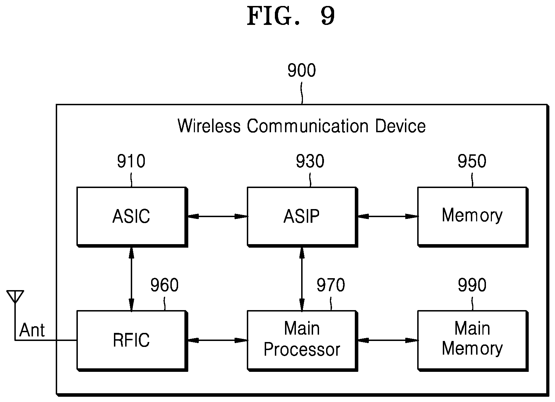

FIG. 9 is a block diagram of a wireless communication device 900, according to an embodiment.

Referring to FIG. 9, the wireless communication device 900 may include a modem and a radio frequency integrated circuit (RFIC) 960. The modem may include an application specific integrated circuit (ASIC) 910, an application specific instruction set processor (ASIP) 930, a memory 950, a main processor 970, and a main memory 990. The wireless communication device 900 of FIG. 9 may include and/or may be similar in many respects to the electronic device 100 described above with reference to FIG. 1, and may include additional features not mentioned above. Consequently, repeated descriptions of the wireless communication device 900 described above with reference to FIG. 1 may be omitted for the sake of brevity.

The RFIC 960 may be connected to an antenna Ant and may receive signals from the outside and/or may transmit signals to the outside by using a wireless communication network. The ASIP 930 may be and/or may include an integrated circuit customized for a certain purpose, and may support a dedicated instruction set for a certain application and execute instructions included in the instruction set. The memory 950 may communicate with the ASIP 930 and, as a non-transitory storage device, may store a plurality of instructions executed by the ASIP 930. For example, the memory 950 may include any type of memory accessible by the ASIP 930, such as, but not limited to, random access memory (RAM), read only memory (ROM), tape, magnetic disks, optical disks, volatile memory, non-volatile memory, and combinations thereof.

The main processor 970 may control the wireless communication device 900 by executing the plurality of instructions. For example, the main processor 970 may control the ASIC 910 and the ASIP 930, process data received over a wireless communications network, or process user input to the wireless communication device 900. The main memory 990 may communicate with the main processor 970 and, as a non-transitory storage device, may store the plurality of instructions executed by the main processor 970. For example, the main memory 990 may include any type of memory accessible by the main processor 970, such as, but not limited to, RAM, ROM, tape, magnetic disks, optical disks, volatile memory, non-volatile memory, and combinations thereof.

As described above, the embodiments have been disclosed in the drawings and specifications. Although specific terms have been used to describe embodiments in this specification, they have been used only for the purpose of explaining the present disclosure and are not intended to limit the meaning or the scope of the present disclosure set forth in the claims. Therefore, a person having ordinary skill in the art is to understand that various modifications and equivalent other embodiments may be made from this. Therefore, the true technical protection scope of the present disclosure should be determined by the technical idea of the appended claims.

While the present disclosure has been particularly shown and described with reference to embodiments thereof, it is to be understood that various changes in form and details may be made therein without departing from the scope of the following claims.

## Claims

1. An adaptive digital pre-distortion device, comprising:
a legacy digital pre-distortion (DPD) device (620);
one or more processors (130) comprising processing circuitry; and
a memory (120) storing instructions,
wherein the instructions, when executed by the one or more processors (130) individually or collectively, cause the adaptive DPD device to:
receive a plurality of system parameters;
estimate, using a neural network (610), one or more coefficients of the legacy DPD device (620), the neural network (610) being configured to generate, as outputs, the one or more coefficients based on the plurality of system parameters; and
apply the one or more coefficients to the legacy DPD device (620).

2. The adaptive digital pre-distortion device of claim 1, wherein the plurality of system parameters comprise at least one of a type of a power amplifier (330), a system bandwidth, a modulation order, a bias voltage of the power amplifier (330), an output voltage of the power amplifier (330), a target voltage of the power amplifier (330), a gain of the power amplifier (330), an operation frequency of the power amplifier (330), or a center frequency of the power amplifier (330).

3. The adaptive digital pre-distortion device of claim 1 or claim 2, wherein the instructions, when executed by the one or more processors (130) individually or collectively, further cause the adaptive DPD device to determine an operation mode of the neural network (610).

4. The adaptive digital pre-distortion device of any preceding claim, wherein the operation mode comprises at least one of a first operation mode in which training of the neural network (610) is performed based on transmission data (TX data) of each sample, a second operation mode in which the transmission data (TX data) is temporarily stored in a buffer memory and the training of the neural network (610) is performed based on the transmission data (TX data) stored in the buffer memory, or a third operation mode in which the training of the neural network (610) is performed based on monitoring of a performance indicator of a power amplifier (330) of the adaptive DPD device .

5. The adaptive digital pre-distortion device of claim 4, wherein the performance indicator corresponds to an adjacent channel leakage ratio (ACLR).

6. The adaptive digital pre-distortion device of claim 4 or claim 5, wherein the instructions, when executed by the one or more processors (130) individually or collectively, further cause the adaptive DPD device to perform training of the neural network (610) based on identifying that the performance indicator is below a threshold value.

7. An electronic device (100), comprising:
a communication circuit (110) comprising:
an adaptive digital pre-distortion (DPD) device comprising a legacy DPD device (620) and a neural network device (610); and
a power amplifier (330) configured to amplify an output of the adaptive DPD device,
wherein the neural network device (610) is configured to:
receive a plurality of system parameters as inputs; and
generate coefficients of the legacy DPD device (620) as outputs;
a processor (120) configured to:
determine an operation mode of the neural network device (610); and
provide the plurality of system parameters to the neural network device (610); and
a memory (120) storing weights of the neural network device.

8. The electronic device (100) of claim 7, wherein the communication circuit (110) further comprises:
a modulator circuit (310) configured to:
receive transmission data (TX data); and
perform modulation on the transmission data (TX data); and
a crest factor reduction (CFR) circuit (310) configured to:
perform clipping on modulated transmission data; and
output the modulated transmission data to the legacy DPD device (620).

9. The electronic device (100) of claim 8, wherein the legacy DPD device (620) is configured to perform pre-distortion on the modulated transmission data based on the coefficients output by the neural network device (610).

10. The electronic device (100) of any of claims 7-9, wherein the plurality of system parameters comprise at least one a type of the power amplifier (330), a system bandwidth, a modulation order, a bias voltage of the power amplifier (330), an output voltage of the power amplifier (330), a target voltage of the power amplifier (330), a gain of the power amplifier (330), an operation frequency of the power amplifier (330), a center frequency of the power amplifier (330).

11. The electronic device (100) of any of claims 7-10, wherein the operation mode comprises at least one of:
a first operation mode in which training of the neural network (610) device is performed based on transmission data (TX data) of each sample;
a second operation mode in which the transmission data (TX data) is temporarily stored in a buffer memory and the training of the neural network device (610) is performed based on the transmission data (TX data) stored in the buffer memory; or
a third operation mode in which the training of the neural network device (610) is performed based on monitoring of a performance indicator of the power amplifier (330).

12. The electronic device (100) of any of claims 8-11, further comprising a feedback device (740) configured to feedback an output obtained by performing, by the legacy DPD device (620), pre-distortion on the modulated transmission data.

13. The electronic device (100) of claim 12, further comprising a scaling/phase compensation device (750) configured to:
scale an output of the legacy DPD device (620) from the feedback device (740) to have a same size as a size of the modulated transmission data; and
perform phase and delay compensation on the output to match the modulated transmission data.

14. The electronic device (100) of claim 13, further comprising:
an error calculation device (760) configured to calculate an error by subtracting the modulated transmission data from an output of the scaling/phase compensation device (750).

15. The electronic device (100) of claim 14, wherein the error calculation device (760) is further configured to provide the calculated error to the neural network device (620), and
wherein the neural network device (610) is further configured to train a neural network by performing a backpropagation operation using the calculated error.
